(19) **Europäisches Patentamt**
**European Patent Office**
**Office européen des brevets**

(11) **EP 2 395 670 B1**

(12) **EUROPEAN PATENT SPECIFICATION**

(45) Date of publication and mention
of the grant of the patent:
**26.04.2017 Bulletin 2017/17**

(51) Int Cl.:
**H04B 1/04** *(2006.01)* **H03L 7/093** *(2006.01)*

(21) Application number: **11165357.2**

(22) Date of filing: **09.05.2011**

(54) **Emission suppression for wireless communication devices**

Emissionsunterdrückung für drahtlose Kommunikationsvorrichtungen

Suppression des émissions pour dispositifs de communication sans fil

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.06.2010 US 796229**

(43) Date of publication of application:
**14.12.2011 Bulletin 2011/50**

(73) Proprietor: **Intel IP Corporation
Santa Clara, CA 95054 (US)**

(72) Inventors:
• **Xu, Bing
Gilbert, AZ 85234 (US)**
• **Zhao, Chunming
Tempe, AZ 85284 (US)**

(74) Representative: **2SPL Patentanwälte PartG mbB
Postfach 15 17 23
80050 München (DE)**

(56) References cited:
**WO-A1-2009/036221     US-A1- 2006 255 868
US-A1- 2007 111 675**

**Description**

TECHNICAL FIELD OF THE INVENTION

The present invention relates generally to wireless communication and, more particularly, to emission suppression for wireless communication devices.

BACKGROUND

In a wireless communication system, a transmitter modulates data onto a radio frequency (RF) carrier signal to generate an RF modulated signal that is more suitable for transmission. The transmitter then transmits the RF modulated signal via a wireless channel to a receiver. Transmitters often include components known as phase-locked loops (PLLs). An RF PLL may serve many functions in a transmitter, including generating RF local oscillator signal for up-converting base-band signals onto an RF carrier and for performing modulation.

Commercial wireless communications devices must be compliant with relevant government regulations and industrial specifications, including without limitation, 3rd Generation Partnership Project (3GPP) specifications and United States Federal Communications Commission (FCC) out-of-band emission regulations as set forth in Title 47 of the FCC regulations.

Under 3GPP specifications, power spectrum limits for output RF spectrum due to modulation (modORFS) are -60 decibels referenced to carrier (dBc) at frequency offsets of 400 and 600 kHz from the RF carrier frequency. In addition, power spectrum limits for output RF spectrum due to switching transients (swORFS) are -23 decibels referenced to one milliwatt (dBm) at a frequency offset of 400 kHz from the RF carrier frequency and -26 dBm at a frequency offset of 600 KHz from the RF carrier frequency.

Under FCC Title 47 regulations, the power of any emission outside of authorized operating frequency ranges must be attenuated below the transmitting power (P) by a factor of at least 43 + 10log10(P) dB. This requires for -13 dBm of power over an integration bandwidth of 100 kHz.

Typically, to meet requirements under FCC Title 47, the output spectrum of a transmitter needs to be filtered. The present disclosure provides efficient methods and systems for the filtering.

However, meeting modORFS and swORFS requirements presents challenges different from meeting FCC Title 47 requirements. As mentioned above, transmitters often use PLLs. In many PLL architectures, a reference clock is typically used and it is often shaped by a squaring circuit before it is sent to a phase detector. Due to nonlinearity of PLL loop blocks, harmonics of the reference clock are generated and passed on to the output via various mechanisms. In the case of harmonics located at 400 or 600 KHz offset from the on-channel local oscillator frequency, such harmonics may cause failure in meeting modORFS requirements at those frequency offsets. Such channels' harmonics are often referred to as near-integer modORFS channels.

Traditionally, the problem of near-integer modORFS channels are solved by improving isolation of PLL elements during layout of the PLL circuit. However, such an approach often requires multiple attempts at manufacturing the PLL (e.g., multiple "tape-outs" for photolithography of the circuits), and may result in time-to-market and cost concerns.

Various conventional PLL circuit concepts are disclosed in WO 2009/036221 A1, US 2006/0255868 A1 or US 2007/111675 A1.

SUMMARY

The present disclosure proposes transmitting sources, corresponding methods, and phase-locked loops according to the independent claims.

Technical advantages of one or more embodiments of the present invention may include suppression of emission at near-integer modORFS channels or channels problematic under FCC Title 47 without the necessity of improving isolation at the layout stage of development, as is often required in traditional approaches.

It will be understood that the various embodiments of the present invention may include some, all, or none of the enumerated technical advantages. In addition, other technical advantages of the present invention may be readily apparent to one skilled in the art from the figures, description and claims included herein.

BRIEF DESCRIPTION OF THE DRAWINGS

For a more complete understanding of the present invention and its features and advantages, reference is now made to the following description, taken in conjunction with the accompanying drawings, in which:

FIGURE 1 illustrates a block diagram of an example wireless communication system, in accordance with certain embodiments of the present disclosure;
FIGURE 2 illustrates a block diagram of an example transmitting source, in accordance with certain embodiments of the present disclosure;
FIGURE 3 illustrates a block diagram of a phase locked loop (PLL), in accordance with certain embodiments of the present disclosure; and
FIGURE 4 illustrates a flow chart of an example method for suppressing emission in wireless communications devices, in accordance with certain embodiments of the present disclosure.

DETAILED DESCRIPTION

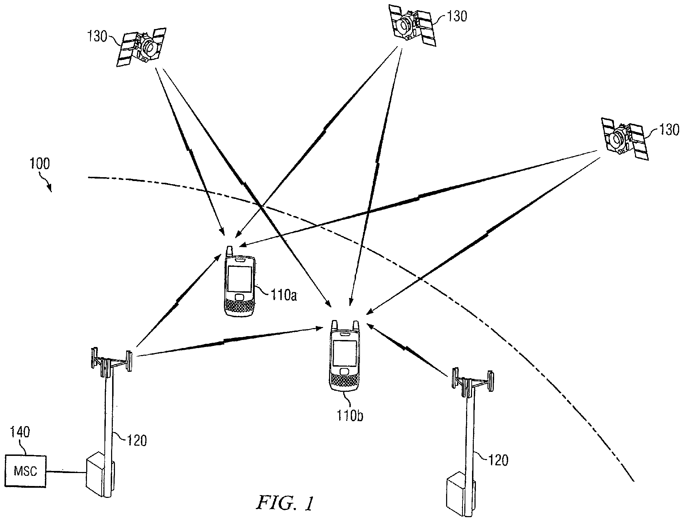

FIGURE 1 illustrates a block diagram of an example wireless communication system 100, in accordance with certain embodiments of the present disclosure.

For simplicity, only two terminals 110 and two base stations 120 are shown in FIGURE 1. A terminal 110 may also be referred to as a remote station, a mobile station, an access terminal, user equipment (UE), a wireless communication device, a cellular phone, or some other terminology. A base station 120 may be a fixed station and may also be referred to as an access point, a Node B, or some other terminology. A mobile switching center (MSC) 140 may be coupled to the base stations 120 and may provide coordination and control for base stations 120.

A terminal 110 may or may not be capable of receiving signals from satellites 130. Satellites 130 may belong to a satellite positioning system such as the well-known Global Positioning System (GPS). Each GPS satellite may transmit a GPS signal encoded with information that allows GPS receivers on earth to measure the time of arrival of the GPS signal. Measurements for a sufficient number of GPS satellites may be used to accurately estimate a three-dimensional position of a GPS receiver. A terminal 110 may also be capable of receiving signals from other types of transmitting sources such as a Bluetooth transmitter, a Wireless Fidelity (Wi-Fi) transmitter, a wireless local area network (WLAN) transmitter, an IEEE 802.11 transmitter, and any other suitable transmitter.

In FIGURE 1, each terminal 110 is shown as receiving signals from multiple transmitting sources simultaneously, where a transmitting source may be a base station 120 or a satellite 130. In some embodiments, a terminal 110 may also be a transmitting source. In general, a terminal 110 may receive signals from zero, one, or multiple transmitting sources at any given moment.

System 100 may be a Code Division Multiple Access (CDMA) system, a Time Division Multiple Access (TDMA) system, or some other wireless communication system. A CDMA system may implement one or more CDMA standards such as IS-95, IS-2000 (also commonly known as "1x"), IS-856 (also commonly known as "IxEV-DO"), Wideband-CDMA (W-CDMA), and so on. A TDMA system may implement one or more TDMA standards such as Global System for Mobile Communications (GSM). The W-CDMA standard is defined by a consortium known as 3GPP, and the IS-2000 and IS-856 standards are defined by a consortium known as 3GPP2.

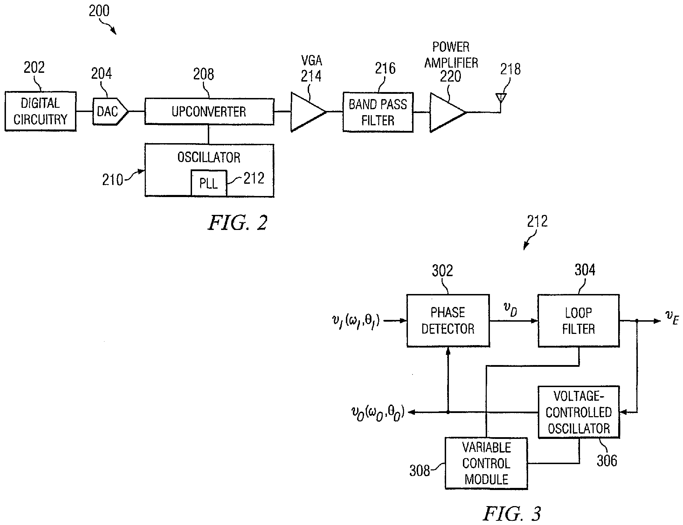

FIGURE 2 illustrates a block diagram of an example transmitting source 200 (e.g., a terminal 110, a base station 120, or a satellite 130), in accordance with certain embodiments of the present disclosure. Transmitting 200 source may include digital circuitry 202 that may process various digital signals and information for which analog signals associated with such digital signals are to be transmitted from transmitting source 200. Transmitting source 200 may include a digital-to-analog converter (DAC) 204. DAC 204 may be configured to receive a digital signal from digital circuitry 202 and convert such digital signal into an analog signal. Such analog signal may then be passed to one or more other components of transmitting source 200, including upconverter 208.

Upconverter 208 may be configured to frequency upconvert an analog signal received from DAC 204 to a wireless communication signal at a radio frequency based on an oscillator signal provided by oscillator 210. Oscillator 210 may be any suitable device, system, or apparatus configured to produce an analog waveform of a particular frequency for modulation or upconversion of an analog signal to a wireless communication signal. As shown in FIGURE 2, oscillator may include a phase-locked loop (PLL) 212. PLL 212 may be a control system configured to generate a signal that has a fixed relation to the phase of a "reference" input signal by responding to both the frequency and the phase of the input signal, and automatically raising or lowering the frequency of a controlled oscillator until it is matched to the reference in both frequency and phase. PLL 212 may be described in greater detail below with reference to FIGURE 3.

Transmitting source 200 may include a variable-gain amplifier (VGA) 214 to amplify an upconverted signal for transmission, and a bandpass filter 216 configured to receive an amplified signal VGA 214 and pass signal components in the band of interest and remove out-of-band noise and undesired signals. The bandpass filtered signal may be received by power amplifier 220 where it is amplified for transmission via antenna 218. Antenna 218 may receive the amplified and transmit such signal (e.g., to one or more terminals 200).

Although methods and systems disclosed herein make reference to transmissions of signals, analogous methods and system may be applied to receptions of signals. Accordingly, as used in this disclosure, "communication" of signals may refer to either or both of signal transmission and signal reception.

FIGURE 3 illustrates a block diagram of PLL 212, in accordance with certain embodiments of the present disclosure. PLL 212 is a frequency-selective circuit designed to synchronize an incoming signal, $v_I(\omega_I, \theta_I)$ and maintain synchronization in spite of noise or variations in the incoming signal frequency. As depicted in FIGURE 3, PLL 212 may comprise a phase detector 302, a loop filter 304, a voltage-controlled oscillator (VCO) 306, and a variable control module 308.

Phase detector 302 may be configured to compare the phase $\theta_I$ of the incoming signal to the phase $\theta_O$ of the VCO 306 output $v_O$, and product a voltage $v_D$ proportional to the difference $\theta_I - \theta_O$. Voltage $v_D$ may be filtered by loop filter 304 to suppress high-frequency ripple and noise, and the result, called the error voltage $v_E$, may be applied to a control input of VCO 306 to adjust its frequency $\omega_O$. VCO 306 may be configured such that with $v_E = 0$ is it oscillating at some initial frequency $\omega_0$, known as the free-running frequency, so that the characteristic of VCO 306 is:

$$\omega_O = \omega_0 + K_V v_E\,(t).$$

where $K_V$ is the gain of VCO 306, in radians-per-second per volt. If a periodic input is applied to PLL 212 with frequency $\omega_I$ sufficiently close to the free-running frequency ($\omega_O$, an error voltage $v_E$ will develop, which will adjust $\omega_O$ until $v_O$ becomes synchronized, or locked, with $v_I$. Should $\omega_I$ change, the phase shift between $v_O$ and $v_I$ will start to increase, changing $v_D$ and $v_E$. VCO 306 may be configured such that this change in $v_E$ adjusts $\omega_O$ until it is brought back the same value as $\omega_I$, allowing the PLL 212, once locked, to track input frequency changes.

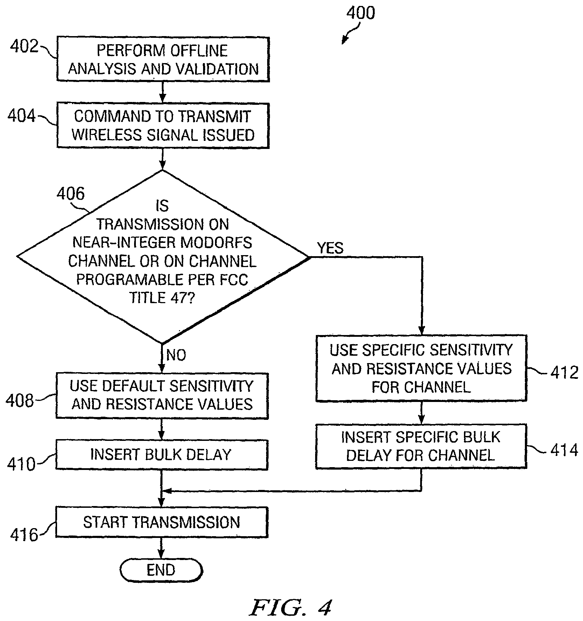

Variable control module 308 may be configured to control the gain $K_V$ of VCO 306 and resistance of resistive components of loop filter 304. A given design of PLL 212 will have a limited number of near-integer modORFS channels, which may be identified through simple harmonics and lab validation. When transmitting on such channels, variable control module 308 may control gain and resistance values to lower the loop bandwidth of PLL 212. As a result of the narrower loop bandwidth, higher in-band distortion may occur, resulting in a higher global phase error. Variable control module 308 may also control the group delay difference among channels, to ensure all channels have the same data path delay. Functionality of variable control module 308 and other components of PLL 212 is described in greater detail below with reference to FIGURE 4.

FIGURE 4 illustrates a flow chart of an example method 400 for suppressing emission in wireless communications devices, in accordance with certain embodiments of the present disclosure. According to one embodiment, method 400 may begin at step 402. As noted above, teachings of the present disclosure may be implemented in a variety of configurations of system 100. As such, the initialization point for method 400 and the order of the steps 402-416 comprising method 400 may depend on the implementation chosen.

At step 402, a manufacturer may perform offline analysis and validation for transmitting source 200 and/or PLL 212. The analysis and validation may include creating a list of potentially problematic channels for PLL 212 (e.g. near-integer modORFS channels, channels potentially problematic under FCC Title 47, and other channels with potentially problematic emission spectrum), creating a list of gain and loop filter resistance values for individual channels, and creating a list of delay values for individual channels. Creation of these lists may be based on testing, analysis, and validation of transmitting source 200 and/or PLLs 212 in order to find values for gain and resistance that effectively reduce near-integer modORFS problems for particular channels. Such lists may be stored on any component of transmitting source 200, including without limitation variable control module 308.

At step 404, after transmitting source 200 and/or PLL 212 have been manufactured, a command may be issued to transmit a wireless signal.

At step 406, variable control module 308 or another component of transmitting source 200 determines if the transmission will occur on a potentially problematic channel. If the transmission will not occur on a potentially problematic channel, method 400 may proceed to step 408. Otherwise, if the transmission will occur on a potentially problematic channel, method 400 may proceed to step 412.

At step 408, in response to a determination that the transmission will not occur on a potentially problematic channel, variable control module 308 and/or another component of transmitting source 200 may apply default gain and resistance values to be used by PLL 212. At step 410, variable control module 308 and/or another component of transmitting source 200 may apply a default bulk delay to be used by PLL 212. After completion of step 410, method 400 may proceed to step 416.

At step 412, in response to a determination that the transmission will occur on a potentially problematic channel, variable control module 308 and/or another component of transmitting source 200 may apply the gain and resistance values specific to the near-integer modORFS channel to be used by PLL 212. At step 414, variable control module 308 and/or another component of transmitting source 200 may apply the fine delay specific to the near-integer modORFS channel to be used by PLL 212. After completion of step 414, method 400 may proceed to step 416.

At step 416, transmission source 200 may begin transmitting, with PLL 212 using the gain, resistance, and delay values used in either of steps 408/410 or steps 412/414. After completion of step 416, method 400 may end.

Although FIGURE 4 discloses a particular number of steps to be taken with respect to method 400, method 400 may be executed with greater or lesser steps than those depicted in FIGURE 4. In addition, although FIGURE 4 discloses a certain order of steps to be taken with respect to method 400, the steps comprising method 400 may be completed in any suitable order.

Method 400 may be implemented using system 100 or any other system operable to implement method 400. In certain embodiments, method 400 may be implemented partially or fully in software and/or firmware embodied in computer-readable media.

Modifications, additions, or omissions may be made to system 100 from the scope of the disclosure. As a non-limiting example, modifications, additions, or omission may be made to system 100 to permit analogous systems and methods to be applied in order to provide emission suppression for signal reception in addition to the emission suppression for signal reception disclosed in this disclosure. Embodiments other than those depicted in FIGURES 1-4 may also be utilized. The components of system 100 may be integrated or separated. Moreover, the operations of system 100 may be performed by more, fewer, or other components. As used in this document, "each" refers to each member of a set or each member of a subset of a set.

Although the present invention has been described with several embodiments, various changes and modifications may be suggested to one skilled in the art. It is intended that the present invention encompass such changes and modifications as fall within the scope of the appended claims.

**Claims**

1. A transmitting source, comprising:

   an upconverter (208) configured to frequency upconvert an analog signal to a wireless communication signal at a radio frequency based on an oscillator signal; and
   an oscillator (210) coupled to the upconverter (208) and configured to output the oscillator signal to the upconverter (208), the oscillator (210) comprising a phase-locked loop (212), the phase-locked loop being **characterized in that** it is configured to:

   synchronize its output to a signal received at its input; and
   suppress emission at a problem channel by applying at least one of a first gain and a first resistance of the phase-locked (212) loop for a transmission at the problem channel, wherein at least one of the first gain and the first resistance are different from a second gain and a second resistance applied for transmissions at channels other than the problem channel,
   wherein the phase-locked loop (212) is configured to apply a first delay for the phase-locked loop (212) for a transmission at the problem channel, wherein the first delay is different from a second delay applied for transmissions at channels other than the problem channel.

2. The transmitting source according to claim 1, wherein the first gain and second gain are each a gain of a voltage controlled oscillator integral to the phase-locked loop (212).

3. The transmitting source according to claim 1, wherein the first resistance and second resistance are each a resistance integral to a loop filter integral to the phase-locked loop (212).

4. The transmitting source according to claim 1, wherein at least one of the first gain and first resistance value are stored to the phase-locked loop (212).

5. The transmitting source according to claim 1, wherein the transmitting source comprises one of a terminal, a base station, and a satellite.

6. The transmitting source according to claim 1, wherein the potentially problematic channel comprises one of a near-integer modulation output radio frequency spectrum (modORFS) channel, whose harmonics are located at 400 or 600 KHz offset from an on-channel local oscillator frequency, and a channel that may have emission greater than that permitted by the October 2009 edition of FCC Title 47.

7. A method, comprising:

   synchronizing an output of a phase-locked loop (212) to a signal received at its input; **characterized by**
   suppressing emission at a problem channel by applying at least one of a first gain and a first resistance of the phase-locked (212) loop for a communication at the problem channel, wherein at least one of the first gain and the first resistance are different from a second gain and a second resistance applied for communications at channels other than the problem channel; and
   applying a first delay for the phase-locked loop (212) for a communication at the problem channel, wherein the first delay is different from a second delay applied for communications at channels other than the problem channel.

8. The method according to claim 7, wherein the first gain and second gain are each a gain of a voltage controlled oscillator integral to the phase-locked loop (212).

9. The method according to claim 7, wherein the first resistance and second resistance are each a resistance integral to a loop filter integral to the phase-locked loop (212).

10. The method according to claim 7, wherein at least one of the first gain and first resistance value are stored to the phase-locked loop (212).

11. The method according to claim 7, wherein the potentially problematic channel comprises one of a near-integer modulation output radio frequency spectrum (modORFS) channel, whose harmonics are located at 400 or 600 KHz offset from an on-channel local oscillator frequency, and a channel that may have emission greater than that permitted by the October 2009 edition of FCC Title 47.

12. A phase-locked (212) loop comprising:

   a phase detector configured to compare a first phase of an input signal to a second phase of an output signal and produce a first signal proportional to the difference between the second phase and the first phase;

a loop filter coupled to the phase detector and configured to filter the first signal to produce an error signal;

a voltage controlled oscillator (210) configured to produce the output signal based on the error signal; and

**characterized by**

a variable control module configured to:

control at least one of a gain and a resistance of the phase-locked loop (212), wherein the variable control module is configured to

control at least one of the gain and the resistance by applying at least one of a first gain and a first resistance of the phase-locked loop for if the input signal is at a problem channel, wherein at least one of the first gain and the first resistance are different from a second gain and a second resistance applied for communications at channels other than the problem channel and

to control a delay of the phase-locked loop (212) by applying a first delay for the phase-locked loop (212) if the input signal is at the problem channel, wherein the first delay is different from a second delay applied for communications at channels other than the problem channel.

13. The phase-locked loop (212) according to claim 12, wherein at least one of the first gain and first resistance value are stored to the variable control module.

14. The phase-locked loop (212) according to claim 12, wherein the first delay is stored to the variable control module.

15. The phase-locked loop (212) according to claim 12, wherein the gain comprises a gain of the voltage controlled oscillator (210).

16. The phase-locked loop (212) according to claim 12, wherein the resistance comprises a resistance integral to the loop filter.

17. The phase-locked loop according to claim 12, wherein the potentially problematic channel comprises one of a near-integer modulation output radio frequency spectrum (modORFS) channel, whose harmonics are located at 400 or 600 KHz offset from an on-channel local oscillator frequency, and a channel that may have emission greater than that permitted by the October 2009 edition of FCC Title 47.

**Patentansprüche**

1. Sendequelle, die Folgendes umfasst:

einen Aufwärtskonverter (208), der dafür konfiguriert ist, eine Frequenz-Aufwärtskonvertierung eines analogen Signals zu einem Drahtloskommunikationssignal bei einer Hochfrequenz auf der Basis eines Oszillatorsignals auszuführen; und

einen Oszillator (210), der mit dem Aufwärtskonverter (208) gekoppelt ist und dafür konfiguriert ist, das Oszillatorsignal an den Aufwärtskonverter (208) auszugeben, wobei der Oszillator (210) einen Phasenregelkreis (212) umfasst, wobei der Phasenregelkreis **dadurch gekennzeichnet ist, dass** er für Folgendes konfiguriert ist:

seinen Ausgang mit einem Signal zu synchronisieren, das an seinem Eingang empfangen wurde, und

die Emission auf einem Problemkanal zu unterdrücken, indem eine erste Verstärkung und/oder ein erster Widerstand des Phasenregelkreises (212) für eine Übertragung auf dem Problemkanal angewendet wird, wobei mindestens eines der ersten Verstärkung und des ersten Widerstandes von einer zweiten Verstärkung und einem zweiten Widerstand verschieden sind, die für Übertragungen auf anderen Kanälen als dem Problemkanal angewendet werden, wobei der Phasenregelkreis (212) dafür konfiguriert ist, eine erste Verzögerung für den Phasenregelkreis (212) für eine Übertragung auf dem Problemkanal anzuwenden, wobei die erste Verzögerung eine andere ist als eine zweite Verzögerung, die für Übertragungen auf anderen Kanälen als dem Problemkanal angewendet wird.

2. Sendequelle nach Anspruch 1, wobei die erste Verstärkung und die zweite Verstärkung jeweils eine Verstärkung eines spannungsgesteuerten Oszillators sind, der in den Phasenregelkreis (212) integriert ist.

3. Sendequelle nach Anspruch 1, wobei der erste Widerstand und der zweite Widerstand jeweils ein Widerstand sind, die in ein Schleifenfilter integriert sind, das in den Phasenregelkreis (212) integriert ist.

4. Sendequelle nach Anspruch 1, wobei mindestens eines der ersten Verstärkung und des ersten Widerstandswertes in dem Phasenregelkreis (212) gespeichert ist.

5. Sendequelle nach Anspruch 1, wobei die Sendequelle ein Endgerät oder eine Basisstation oder einen Satelliten umfasst.

**6.** Sendequelle nach Anspruch 1, wobei der potenziell problematische Kanal einen Near-Integer Modulation Output Radio Frequency Spectrum(modORFS)-Kanal umfasst, dessen Oberschwingungen 400 oder 600 KHz von einer kanalinternen Überlagerungsoszillatorfrequenz versetzt angeordnet sind, oder einen Kanal umfasst, der eine größere Emission haben kann als die, durch die Oktober-2009-Ausgabe von FCC Titel 47 zugelassen wird.

**7.** Verfahren, das Folgendes umfasst:

Synchronisieren eines Ausgangs eines Phasenregelkreises (212) mit einem Signal, das an seinem Eingang empfangen wird; **gekennzeichnet durch**

Unterdrücken einer Emission auf einem Problemkanal, indem eine erste Verstärkung und/oder ein erster Widerstand des Phasenregelkreises (212) für eine Kommunikation auf dem Problemkanal angewendet wird, wobei mindestens eines der ersten Verstärkung und des ersten Widerstandes von einer zweiten Verstärkung und einem zweiten Widerstand verschieden sind, die für Kommunikationen auf anderen Kanälen als dem Problemkanal angewendet werden; und

Anwenden einer ersten Verzögerung für den Phasenregelkreis (212) für eine Kommunikation auf dem Problemkanal, wobei die erste Verzögerung eine andere ist als eine zweite Verzögerung, die für Kommunikationen auf anderen Kanälen als dem Problemkanal angewendet wird.

**8.** Verfahren nach Anspruch 7, wobei die erste Verstärkung und die zweite Verstärkung jeweils eine Verstärkung eines spannungsgesteuerten Oszillators sind, der in den Phasenregelkreis (212) integriert ist.

**9.** Verfahren nach Anspruch 7, wobei der erste Widerstand und der zweite Widerstand jeweils ein Widerstand sind, die in ein Schleifenfilter integriert sind, das in den Phasenregelkreis (212) integriert ist.

**10.** Verfahren nach Anspruch 7, wobei mindestens eines der ersten Verstärkung und des ersten Widerstandswertes in dem Phasenregelkreis (212) gespeichert ist.

**11.** Verfahren nach Anspruch 7, wobei der potenziell problematische Kanal einen Near-Integer Modulation Output Radio Frequency Spectrum (modORFS)-Kanal umfasst, dessen Oberschwingungen 400 oder 600 KHz von einer kanalinternen Überlagerungsoszillatorfrequenz versetzt angeordnet sind, oder einen Kanal umfasst, der eine größere Emission haben kann als die, durch die Oktober-2009-Ausgabe von FCC Titel 47 zugelassen wird.

**12.** Phasenregelkreis (212), der Folgendes umfasst:

einen Phasendetektor, der dafür konfiguriert ist, eine erste Phase eines Eingangssignals mit einer zweiten Phase eines Ausgangssignals zu vergleichen und ein erstes Signal zu erzeugen, das proportional zu der Differenz zwischen der zweiten Phase und der ersten Phase ist; ein Schleifenfilter, das mit dem Phasendetektor gekoppelt ist und dafür konfiguriert ist, das erste Signal zu filtern, um ein Fehlersignal zu erzeugen; einen spannungsgesteuerten Oszillator (210), der dafür konfiguriert ist, das Ausgangssignal auf der Basis des Fehlersignals zu erzeugen; und **gekennzeichnet durch** ein variables Steuermodul, das für Folgendes konfiguriert ist:

Steuer einer Verstärkung und/oder eines Widerstands des Phasenregelkreises (212),

wobei das variable Steuermodul für Folgendes konfiguriert ist:

Steuern der Verstärkung und/oder des Widerstands durch Anwenden einer ersten Verstärkung und/oder eines ersten Widerstands des Phasenregelkreises, falls sich das Eingangssignal auf einem Problemkanal befindet, wobei mindestens eines der ersten Verstärkung und des ersten Widerstands von einer zweiten Verstärkung und einem zweiten Widerstand verschieden sind, die für Kommunikationen auf anderen Kanälen als dem Problemkanal angewendet werden, und

Steuern einer Verzögerung des Phasenregelkreises (212) **durch** Anwenden einer ersten Verzögerung für den Phasenregelkreis (212), falls sich das Eingangssignal auf dem Problemkanal befindet, wobei die erste Verzögerung eine andere ist als eine zweite Verzögerung, die für Kommunikationen auf anderen Kanälen als dem Problemkanal angewendet werden.

**13.** Phasenregelkreis (212) nach Anspruch 12, wobei mindestens eines der ersten Verstärkung und des ersten Widerstandswertes in dem variablen Steuermodul gespeichert werden.

**14.** Phasenregelkreis (212) nach Anspruch 12, wobei die erste Verzögerung in dem variablen Steuermodul gespeichert wird.

**15.** Phasenregelkreis (212) nach Anspruch 12, wobei die Verstärkung eine Verstärkung des spannungsgesteuerten Oszillators (210) umfasst.

**16.** Phasenregelkreis (212) nach Anspruch 12, wobei der Widerstand einen Widerstand umfasst, der in das Schleifenfilter integriert ist.

**17.** Phasenregelkreis nach Anspruch 12, wobei der potenziell problematische Kanal einen Near-Integer Modulation Output Radio Frequency Spectrum (modORFS)-Kanal umfasst, dessen Oberschwingungen 400 oder 600 KHz von einer kanalinternen Überlagerungsoszillatorfrequenz versetzt angeordnet sind, oder einen Kanal umfasst, der eine größere Emission haben kann als die, die durch die Oktober-2009-Ausgabe von FCC Titel 47 zugelassen wird.

## Revendications

**1.** Source de transmission comprenant :

un convertisseur élévateur de fréquence (208) configuré pour convertir avec élévation de fréquence un signal analogique en un signal de communication sans fil à une fréquence radio basée sur un signal d'oscillateur ; et
un oscillateur (210) couplé au convertisseur élévateur de fréquence (208) et configuré pour transmettre le signal d'oscillateur au convertisseur élévateur de fréquence (208), l'oscillateur (210) comprenant une boucle à verrouillage de phase (212), la boucle à verrouillage de phase étant **caractérisée en ce qu'**elle est configurée pour :

synchroniser sa sortie avec un signal reçu au niveau de son entrée ; et
supprimer une émission au niveau d'un canal à problème en appliquant un premier gain et/ou une première résistance de la boucle à verrouillage de phase (212) pour une transmission au niveau du canal à problème, dans laquelle le premier gain et/ou la première résistance sont différents d'un second gain et d'une seconde résistance appliqués pour des transmissions au niveau de canaux autres que le canal à problème, dans laquelle la boucle à verrouillage de phase (212) est configurée pour appliquer un premier retard pour la boucle à verrouillage de phase (212) pour une transmission au niveau du canal à problème, dans laquelle le premier retard est différent d'un second retard appliqué pour des transmissions au niveau de canaux autres que le canal à problème.

**2.** Source de transmission selon la revendication 1, dans laquelle le premier gain et le second gain sont chacun un gain d'un oscillateur commandé en tension intégré à la boucle à verrouillage de phase (212).

**3.** Source de transmission selon la revendication 1, dans laquelle la première résistance et la seconde résistance sont chacune une résistance intégrée à un filtre à boucle intégré à la boucle à verrouillage de phase (212).

**4.** Source de transmission selon la revendication 1, dans laquelle la valeur du premier gain et/ou la valeur de la première résistance sont stockées dans la boucle à verrouillage de phase (212).

**5.** Source de transmission selon la revendication 1, dans laquelle la source de transmission comprend un terminal ou une station de base ou un satellite.

**6.** Source de transmission selon la revendication 1, dans laquelle le canal potentiellement problématique comprend soit un canal de spectre de fréquence radio de sortie de modulation (modORFS) d'entiers proches, dont les harmoniques sont situées selon un décalage de 400 ou de 600 KHz par rapport à une fréquence d'oscillateur local sur un canal, soit un canal qui peut présenter une émission supérieure à celle permise par l'édition d'octobre 2009 du titre 47 du FCC.

**7.** Procédé consistant à :

synchroniser une sortie d'une boucle à verrouillage de phase (212) avec un signal reçu au niveau de son entrée ; **caractérisé par** le fait de :

supprimer une émission au niveau d'un canal à problème en appliquant un premier gain et/ou une première résistance de la boucle à verrouillage de phase (212) pour une communication au niveau du canal à problème, dans lequel le premier gain et/ou la première résistance sont différents d'un second gain et d'une seconde résistance appliqués pour des communications au niveau de canaux autres que le canal à problème ; et
appliquer un premier retard pour la boucle à verrouillage de phase (212) pour une communication au niveau du canal à problème, dans lequel le premier retard est différent d'un second retard appliqué pour des communications au niveau de canaux autres que le canal à problème.

8. Procédé selon la revendication 7, dans lequel le premier gain et le second gain sont chacun un gain d'un oscillateur commandé en tension intégré à la boucle à verrouillage de phase (212).

9. Procédé selon la revendication 7, dans lequel la première résistance et la seconde résistance sont chacune une résistance intégrée à un filtre à boucle intégré à la boucle à verrouillage de phase (212).

10. Procédé selon la revendication 7, dans lequel la valeur du premier gain et/ou la valeur de la première résistance sont stockées dans la boucle à verrouillage de phase (212).

11. Procédé selon la revendication 7, dans lequel le canal potentiellement problématique comprend soit un canal de spectre de fréquence radio de sortie de modulation (modORFS) d'entiers proches, dont les harmoniques sont situées selon un décalage de 400 ou de 600 KHz par rapport à une fréquence d'oscillateur local sur un canal, soit un canal qui peut présenter une émission supérieure à celle permise par l'édition d'octobre 2009 du titre 47 du FCC.

12. Boucle à verrouillage de phase (212) comprenant :

un détecteur de phase configuré pour comparer une première phase d'un signal d'entrée à une seconde phase d'un signal de sortie et produire un premier signal proportionnel à la différence entre la seconde phase et la première phase ; un filtre à boucle couplé au détecteur de phase et configuré pour filtrer le premier signal afin de produire un signal d'erreur ; un oscillateur commandé en tension (210) configuré pour produire un signal de sortie en se basant sur le signal d'erreur ; et **caractérisée par** un module de commande de variable configuré pour :

commander un gain et/ou une résistance de la boucle à verrouillage de phase (212), dans laquelle le module de commande de variable est configuré pour commander le gain et/ou la résistance en appliquant un premier gain et/ou une première résistance de la boucle à verrouillage de phase si le signal d'entrée est au niveau d'un canal à problème, dans laquelle le premier gain et/ou la première résistance sont différents d'un second gain et d'une seconde résistance appliqués pour des communications au niveau de canaux autres que le canal à problème, et pour commander un retard de la boucle à verrouillage de phase (212) en appliquant un premier retard pour la boucle à verrouillage de phase (212) si le signal d'entrée est au niveau du canal à problème, dans laquelle le premier retard est différent d'un second retard appliqué pour des communications au niveau de canaux autres que le canal à problème.

13. Boucle à verrouillage de phase (212) selon la revendication 12, dans laquelle la valeur du premier gain et/ou la valeur de la première résistance sont stockées dans le module de commande de variable.

14. Boucle à verrouillage de phase (212) selon la revendication 12, dans laquelle le premier retard est stocké dans le module de commande de variable.

15. Boucle à verrouillage de phase (212) selon la revendication 12, dans laquelle le gain comprend un gain de l'oscillateur commandé en tension (210).

16. Boucle à verrouillage de phase (212) selon la revendication 12, dans laquelle la résistance comprend une résistance intégrée au filtre à boucle.

17. Boucle à verrouillage de phase selon la revendication 12, dans laquelle le canal potentiellement problématique comprend soit un canal de spectre de fréquence radio de sortie de modulation (modORFS) d'entiers proches, dont les harmoniques sont situées selon un décalage de 400 ou de 600 KHz par rapport à une fréquence d'oscillateur local sur un canal, soit un canal qui peut présenter une émission supérieure à celle permise par l'édition d'octobre 2009 du titre 47 du FCC.

*FIG. 1*

200

| 202 | 204 | 208 | VGA 214 | 216 | POWER AMPLIFIER 220 | 218 |

DIGITAL CIRCUITRY → DAC → UPCONVERTER → ▷ → BAND PASS FILTER → ▷ →

OSCILLATOR

210 — PLL — 212

*FIG. 2*

212

| 302 | $v_D$ | 304 | $v_E$ |

$v_I(\omega_I, \theta_I)$ → PHASE DETECTOR → LOOP FILTER → $v_E$

$v_0(\omega_0, \theta_0)$ ←

VOLTAGE-CONTROLLED OSCILLATOR

VARIABLE CONTROL MODULE

308

306

*FIG. 3*

FIG. 4

**REFERENCES CITED IN THE DESCRIPTION**

**Patent documents cited in the description**

- WO 2009036221 A1
- US 20060255868 A1
- US 2007111675 A1